# EUROPEAN PATENT SPECIFICATION

(11) **EP 3 200 569 B1**
(45) Date of publication and mention of the grant of the patent: **21.04.2021**
(21) Application number: 17153250.0
(22) Date of filing: 26.01.2017
(51) Int. Cl.: H05K 1/02, H01L 23/522, H01L 23/552, H01L 25/065, H04B 3/32

(54) **ELECTRONIC DEVICE AND METHOD FOR TRANSMITTING DATA IN ELECTRONIC DEVICE**
ELEKTRONISCHE VORRICHTUNG UND VERFAHREN ZUR ÜBERTRAGUNG VON DATEN IN DER ELEKTRONISCHEN VORRICHTUNG
DISPOSITIF ÉLECTRONIQUE ET PROCÉDÉ DE TRANSMISSION DE DONNÉES DANS UN DISPOSITIF ÉLECTRONIQUE

(30) Priority: 01.02.2016 US 201662289376 P; 18.01.2017 US 201715408683
(43) Date of publication of application: 02.08.2017
(73) Proprietor: MediaTek Inc., Hsin-Chu 300 (TW)
(72) Inventor: CHANG, Chun-Wei, 104 Taipei City (TW); CHEN, Shang-Pin, 302 Hsinchu County (TW)
(74) Representative: Goddar, Heinz J.

(56) References cited:
- US-A1- 2013 220 690
- US-B2- 8 203 395
- "PROGRAMMABLE COPLANAR FLEXIBLE CIRCUIT", IBM TECHNICAL DISCLOSURE BULLETIN, INTERNATIONAL BUSINESS MACHINES CORP. (THORNWOOD), US, vol. 32, no. 7, 1 December 1989 (1989-12-01), page 426/427, XP000078143, ISSN: 0018-8689

## Description

### BACKGROUND OF THE INVENTION

### Field of the Invention

The invention relates to an electronic device, and more particularly to guard traces of a printed circuit board (PCB) in an electronic device arranged by a chip on the PCB.

### Description of the Related Art

In electronic devices, printed circuit boards (PCBs) are used to mechanically support and electrically connect electronic components using conductive pathways, conductive traces (e.g. signal traces or ground traces) etched from metal sheets laminated onto a non-conductive core substrate. In recent years, an increased amount of input/output (I/O) connections for multi-functional or memory chips has been required for semiconductor chip package design. The impact of this will be pressure on printed circuit board (PCB) fabricators to minimize the width and the space of the conductive traces, or increase the number of layers on the PCB. The conductive traces used to transmit the signals corresponding to the same function need to be arranged and configured in the same manner on the PCB. For example, the conductive traces used to transmit the address/data bus of a memory need to be arranged and configured in parallel, and the spaces between the conductive traces are also small. However, the adjacent conductive traces on the PCB can result in the problem of crosstalk, especially in high signal speed applications. Thus, the crosstalk problem can detrimentally affect the quality of a signal traveling on a conductive trace, thereby affecting the signal reception of the electronic component supported by the PCB.
Relevant background art is disclosed in US 2013/0220690 A1.

Therefore, it is desirable to optimize the arrangement of the conductive traces for avoiding the crosstalk problem on a PCB of an electronic device.

### BRIEF SUMMARY OF THE INVENTION

According to the invention an electronic device as defined in claim 1 and a method for transmitting data from a first chip to a second chip via a plurality of conductive traces of a printed circuit board (PCB) in an electronic device as defined in claim 15 are provided. The electronic device comprises an integrated circuit. The integrated circuit comprises a control circuitry, a plurality of pins coupled to a plurality of conductive traces of a printed circuit board (PCB), and a plurality of driving units coupled to the conductive traces of the PCB via the pins. The control circuitry provides a plurality of control signals according to data to be transmitted. The driving units are divided into a plurality of first driving units and a plurality of second driving units. According to the control signals, the first driving units provide the data to a memory device of the PCB via the corresponding pins and the corresponding conductive traces of PCB, and the second driving units provide at least one constant voltage to the corresponding conductive traces of PCB via the corresponding pins. The conductive traces corresponding to the second driving units are separated by the conductive traces corresponding to the first driving units on the PCB.

In another embodiment the integrated circuit comprises a control circuitry, a plurality of pins coupled to a plurality of conductive traces of a printed circuit board (PCB), and a plurality of driving units coupled to the conductive traces of the PCB via the corresponding pins. The control circuitry provides a plurality of control signals according to data to be transmitted and pin information regarding a memory device of the PCB. When the pin information indicates that the memory device is a first memory, the control signals control the driving units to provide the data to the conductive traces of PCB via the pins. When the pin information indicates that the memory device is a second memory, the control signals control a portion of the driving units to provide the data to the corresponding conductive traces of PCB via the corresponding pins, and the control signals control the other driving units to provide at least one constant voltage to the corresponding conductive traces of PCB via the corresponding pins. A pin number of the first memory is greater than a pin number of the second memory.

An embodiment of an electronic device is provided. The electronic device comprises a printed circuit board (PCB), a first chip mounted on the PCB, and a second chip mounted on the PCB. The PCB comprises a plurality of conductive traces, wherein the conductive traces are divided into a plurality of first conductive traces and a plurality of second conductive traces. The second chip is coupled to the first chip via the first conductive traces. The first chip comprises a plurality of pins coupled to the first and second conductive traces of the PCB, a control circuitry, and a plurality of driving units coupled to the pins. The control circuitry provides a plurality of control signals according to data to be transmitted to the second chip. The control signals control the driving units coupled to the pins corresponding to the first conductive traces of the PCB to provide the data to the second chip, and control the driving units coupled to the pins corresponding to the second conductive traces of the PCB to provide at least one constant voltage to the PCB.

Moreover, an embodiment of method for transmitting data from a first chip to a second chip via a plurality of first conductive traces of a printed circuit board (PCB) in an electronic device is provided, wherein the first chip and the second chip are mounted on the PCB. The first chip provides a plurality of control signals are provided according to the data to be transmitted to the second chip and pin information regarding the second chip. The first chip controls a plurality of first driving units to provide the data to the second chip via the first conductive traces of the PCB. The first chip controls a plurality of second driving units to provide at least one constant voltage to the PCB via a plurality of second conductive traces of the PCB. The first conductive traces are electrically connected to the second chip on the PCB, and the second conductive traces are electrically separated from the second chip on the PCB. Each of the second conductive traces is surrounded by the first conductive traces on the PCB.

A detailed description is given in the following embodiments with reference to the accompanying drawings.

### BRIEF DESCRIPTION OF DRAWINGS

The invention can be more fully understood by reading the subsequent detailed description and examples with references made to the accompanying drawings, wherein:
FIG. 1 shows an electronic device according to an embodiment of the invention;
FIG. 2A shows an example illustrating the arrangement of a plurality of conductive traces between a first chip and a second chip on a PCB according to an embodiment of the invention;
FIG. 2B shows an example illustrating the arrangement of a plurality of conductive traces between the first chip and the second chip on the PCB according to another embodiment of the invention;
FIG. 3 shows an example illustrating a top view of an electronic device according to another embodiment of the invention;
FIG. 4A shows a layout of a first layer on the PCB of FIG. 3;
FIG. 4B shows a layout of a second layer below the first layer on the PCB of FIG. 3;
FIG. 4C shows a layout of a third layer below the second layer on the PCB of FIG. 3;
FIG. 5A shows a cross section illustrating the arrangement of the conductive traces of an exemplary PCB along line A-A' of FIG. 3 according to an embodiment of the invention;
FIG. 5B shows a cross section illustrating the arrangement of the conductive traces of an exemplary PCB along line A-A' of FIG. 3 according to another embodiment of the invention;
FIG. 5C shows a cross section illustrating the arrangement of the conductive traces of an exemplary PCB along line A-A' of FIG. 3 according to another embodiment of the invention; and
FIG. 6 shows a method for transmitting data from a first chip to a second chip via a plurality of conductive traces of a printed circuit board in an electronic device.
FIG. 7 shows an electronic device according to another embodiment of the invention;
FIG. 8 shows a schematic illustrating the conductive traces between the first chip and the second chip on the PCB of FIG. 7 according to an embodiment of the invention; and
FIG. 9 shows a method for transmitting data from a first chip to a second chip via a plurality of conductive traces of a printed circuit board in an electronic device.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is determined by the appended claims.

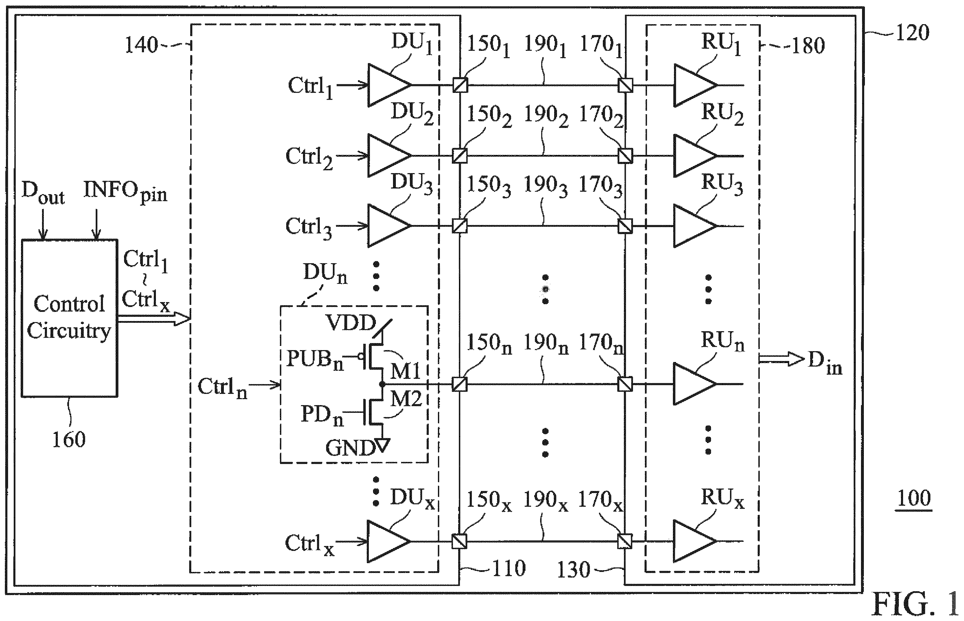

FIG. 1 shows an electronic device 100 according to an embodiment of the invention. The electronic device 100 comprises a first chip 110, a printed circuit board (PCB) 120, and a second chip 130, wherein the first chip 110 and the second chip 130 are mounted on the PCB 120. The first chip 110 is a controller capable of accessing different types of memory devices. In the embodiment, the first chip 110 is operating in a normal mode, and the pin information INFOₚᵢₙ indicates that the second chip 130 is a double data rate type III (DDR3) memory. In the normal mode, the first chip 110 can transmit data with a single data rate to the second chip 130 via a plurality of conductive traces 190₁-190ₓ of the PCB 120. The first chip 110 comprises an output module 140, a plurality of pins 150₁-150ₓ, and a control circuitry 160. The control circuitry receives data Dₒᵤₜ to be provided to the second chip 130 and pin information INFOₚᵢₙ regarding the pin configuration of the second chip 130, and provides a plurality of control signals Ctrl₁-Ctrlₓ to the second chip 130 according to the data Dₒᵤₜ and the pin information INFOₚᵢₙ. In some embodiments, the data Dₒᵤₜ and the pin information INFOₚᵢₙ are obtained from a circuit (e.g. a memory, a processor or other functional circuitry) of the first chip 110 or a device outside the first chip 110. The output module 140 comprises a plurality of driving units DU₁-DUₓ, wherein an output of each driving unit is coupled to the corresponding pin of the first chip 110. For example, the output of the driving unit DU₁ is coupled to the pin 150₁ of the first chip 110, and the output of the driving unit DU₂ is coupled to the pin 150₂ of the first chip 110, and so on. In the embodiment, each of the driving units DU₁-DUₓ has the same circuitry and structure. Taking the driving unit DUₙ as an example, the driving unit DUₙ comprises a PMOS transistor M1 and an NMOS transistor M2. The PMOS transistor M1 is coupled between a power supply VDD and the pin 150ₙ, and the PMOS transistor M1 is controlled by a signal PUBₙ corresponding to the control signal Ctrlₙ. The NMOS transistor M2 is coupled between the pin 150ₙ and a ground GND, and the NMOS transistor M2 is controlled by a signal PDₙ opposite to the signal PUBₙ. In the embodiment, according to the control signal Ctrlₙ, the driving unit DUₙ can provide 1-bit data of the data Dₒᵤₜ to the second chip 130 via the conductive trace 190ₙ of the PCB 120. In some embodiments, the PMOS transistor M1 is formed by a plurality of PMOS transistors connected in parallel, and the NMOS transistor M2 is formed by a plurality of NMOS transistors connected in parallel.

In FIG. 1, the second chip 130 comprises an input module 180 and a plurality of pins 170₁-170ₓ, wherein the input module 180 comprises a plurality of receiving unit RU₁-RUₓ. Each of the receiving units RU₁-RUₓ is coupled to the corresponding conductive trace of the PCB 120 via the corresponding pin of the second chip 130, and is used to receive a signal transmitted in the corresponding conductive trace. For example, the receiving unit RU₁ is coupled to the conductive trace 190₁ of the PCB 120 via the pin 170₁ of the second chip 130, and the receiving unit RU₂ is coupled to the conductive trace 190₂ of the PCB 120 via the pin 170₂ of the second chip 130, and so on. After receiving the signals, the input module 180 is capable of provide an input data Dᵢₙ according to the received signals for subsequent processing.

In some embodiments, the first chip 110 is capable of providing the data Dₒᵤₜ with a first transmission rate R1 in the normal mode and with a second transmission rate R2 in the high-speed mode, wherein the second transmission rate R2 is higher than the first transmission rate R1. In some embodiments, the second transmission rate R2 is twice the first transmission rate R1. Due to the second transmission rate R2 is higher than the first transmission rate R1, the number of transmitted bits per second in the high-speed mode is more than the number of transmitted bits per second in the normal mode, thereby the first chip 110 can use fewer the driving units and the corresponding conductive traces of PCB to transmit the data Dₒᵤₜ. For example, if the first chip 110 is operating in a normal mode, all of the driving units DU₁-DUₓ are used to provide the data Dₒᵤₜ. If the first chip 110 is operating in a high-speed mode, according to the control signal Ctrl₁-Ctrlₓ, a portion of driving units are selected from the driving units DU₁-DUₓ to provide the data Dₒᵤₜ, and the remaining driving units (i.e. the unselected driving units) are used to provide at least one specific shielding pattern to form the guard traces GT for the signal traces ST corresponding to the selected driving units. The specific shielding pattern is formed by a ground signal, a power signal or a random signal. For the second chip 130, the shielding pattern is invalid data, thus the second chip 130 will ignore the shielding pattern. The arrangement of the guard traces and the signal traces will be described below.

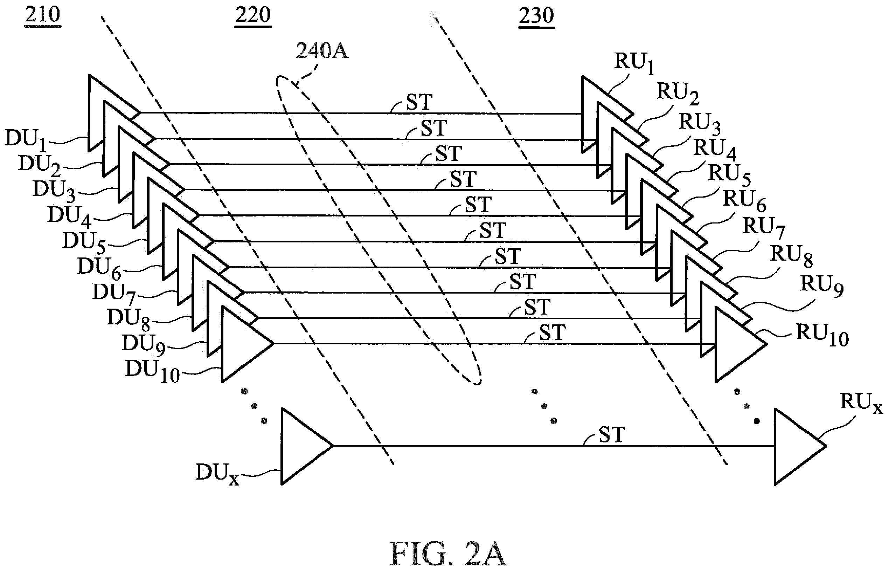

FIG. 2A shows an example illustrating the arrangement of a plurality of conductive traces 240A between a first chip 210 and a second chip 230 on a PCB 220 according to an embodiment of the invention. In order to simplify the description, the pins of the first chip 210 and the second chip 230 will be omitted in FIG. 2A. In the embodiment, the first chip 210 is operating in a normal mode, and the conductive traces 240A are disposed on the same layer of the PCB 220, e.g. a top layer of the PCB 220. As described above, all driving units DU₁-DUₓ of the first chip 210 are used to provide the data Dₒᵤₜ in the normal mode, thereby all of the conductive traces 240A function as the signal traces ST for transmitting the data Dₒᵤₜ to the second chip 230.

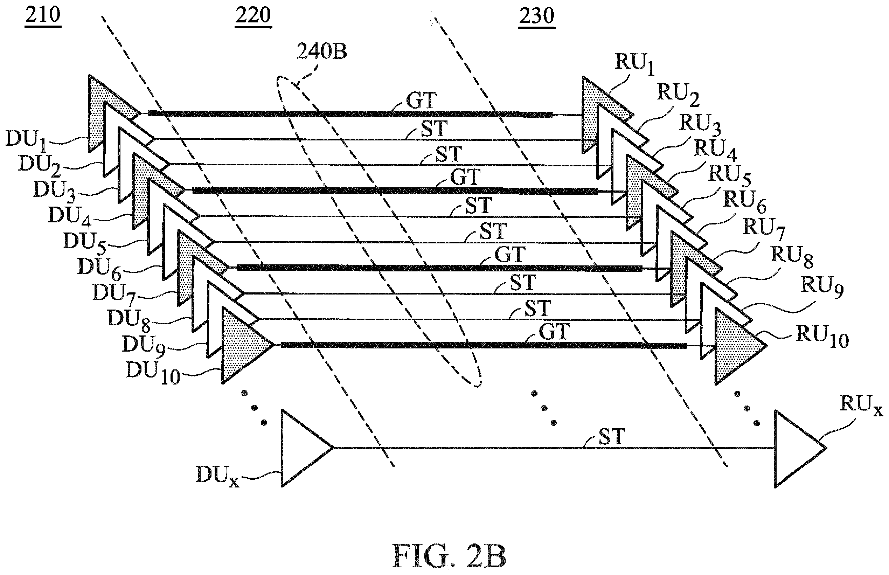

FIG. 2B shows an example illustrating the arrangement of a plurality of conductive traces 240B between the first chip 210 and the second chip 230 on the PCB 220 according to another embodiment of the invention. In order to simplify the description, the pins of the first chip 210 and the second chip 230 will be omitted in FIG. 2B. In the embodiment, the first chip 210 is operating in a high-speed mode, and the conductive traces 240B are disposed on the same layer of the PCB 220, e.g. the top layer of the PCB 220. As described above, a portion of driving units are selected from the driving units DU₁-DUₓ to provide the data Dₒᵤₜ in the high-speed mode, i.e. not all of the driving units DU₁-DUₓ are used to provide the data Dₒᵤₜ. Furthermore, the unselected driving units are used to provide at least one shielding pattern. The specific shielding pattern is formed by a ground signal, a power signal or a random signal. For example, the driving units DU₂-DU₃, DU₅-DU₆, DU₈-DU₉ are selected to provide the data Dₒᵤₜ, thereby the conductive traces 240B corresponding to the selected driving units function as the signal traces ST for transmitting the data Dₒᵤₜ to the second chip 230. Moreover, the unselected driving units DU₁, DU₃, DU₇ and DU₁₀ are used to provide at least one shielding pattern, thereby the conductive traces 240B corresponding to the unselected driving units function as the guard traces GT for reducing crosstalk when the data Dₒᵤₜ is transmitted via the signal traces ST. It should be noted that the guard traces GT are separated by the signal traces ST in FIG. 2B. Furthermore, the shielding pattern transmitted by each guard trace GT can be the same or different. It should be noted that the number of guard traces GT is less than the number of signal traces ST in FIG. 2B.

Traditionally, after obtaining system specification and requisition, a plurality of shielding lines are implemented on a PCB in order to decrease crosstalk problem, wherein the shielding lines are fixedly routed on the PCB and are also inserted into the conductive traces between the devices on the PCB. In general, the shielding lines are coupled to a ground of the PCB. Compared with the traditional shielding lines, the guard traces GT of FIG. 2B will not occupy the additional area on the PCB 220, i.e. the guard traces GT are the unused signal traces existing on the PCB 220, i.e. the unused signal traces ST will be used as the guard traces GT. Specifically, no additional shielding line is fixedly routed and inserted into the conductive traces 240B on the PCB 220, thus decreasing layout size of the PCB 220. Furthermore, the arrangement of the conductive traces 240B is determined according to the outputs of the driving units DU₁-DUₓ of the first chip 210, wherein the outputs of the driving units DU₁-DUₓ are controlled by a control circuitry of the first chip 210, e.g. the control circuitry 160 of FIG. 1, according to the data Dₒᵤₜ. The control circuitry of the first chip 210 can modify the arrangement of the conductive traces 240B via the driving units DU₁-DUₓ according to actual applications. Furthermore, the guard traces can reduce electrical noise from affecting the signals between the first chip 210 and the second chip 230, e.g. avoiding the signal current loops formed in the conductive traces 240B on the PCB 220. In traditional design flows, a shielding design is passively planned according to system specifications in advance. In the embodiment, the interconnection between the first chip 210 and the second chip 230 can be planned in advance, and the layout of signals of the interconnection can be minimized before the system specifications are confirmed. Next, according to the speed of the system specifications, the shielding pattern is modified, thereby obtaining the best electrical performances. Furthermore, the development cost in the layout is also decreased.

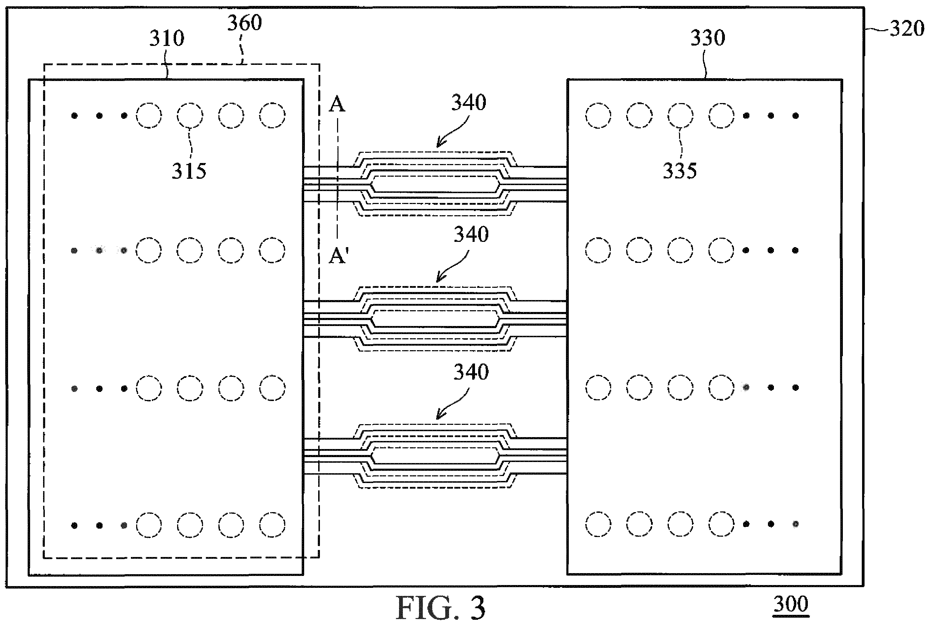

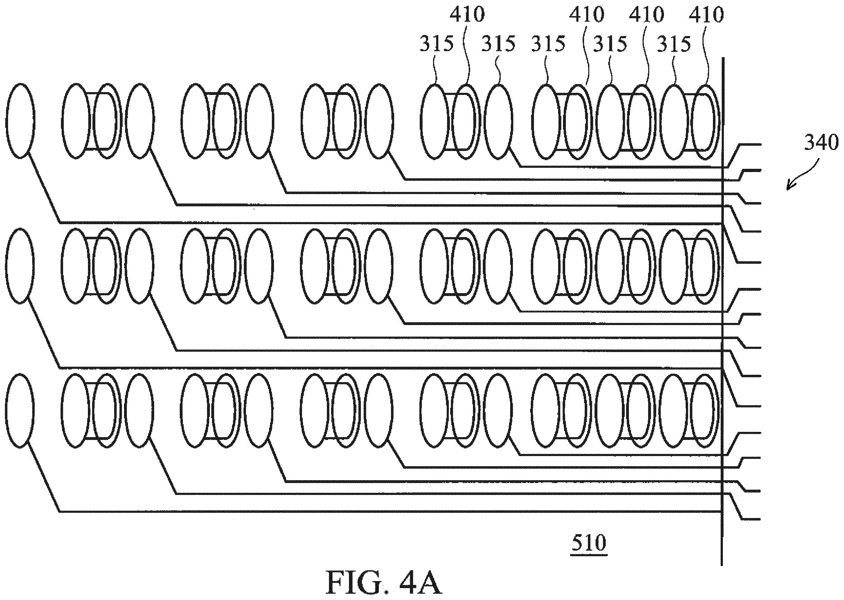

FIG. 3 shows an example illustrating a top view of an electronic device 300 according to another embodiment of the invention. The electronic device 300 comprises a first chip 310, a PCB 320, a second chip 330, and a plurality of conductive traces 340 between the first chip 310 and the second chip 330. By using a flip chip technology, the first chip 310 is bonded on the PCB 320 via a plurality of bumps 315, and the second chip 330 is bonded on the PCB 320 via a plurality of bumps 335. Furthermore, the first chip 310 comprises a plurality of driving units (e.g. the driving units DU₁-DUₓ of FIG. 1) for transmitting data Dₒᵤₜ to the second chip 330, wherein each driving unit is coupled to the individual conductive trace 340 via the corresponding bump 315. As described above, all of the driving units of the first chip 310 are used to provide the data Dₒᵤₜ with a first transmission rate R1 in a normal mode. Furthermore, a portion of driving units are selected to provide the data Dₒᵤₜ with a second transmission rate R2 in a high-speed mode, and the remainder of the driving units are used to provide at least one specific shielding pattern in the high-speed mode, wherein the second transmission rate R2 is higher than the first transmission rate R1. In the embodiment, the conductive traces 340 are disposed on different layers of the PCB 320, and coupled between the bumps 315 of the first chip 310 and the bumps 335 of the second chip 330. The example layout range (labeled as 360) of the bumps 315 of the first chip 310 and the conductive traces 340 are described in FIGs 4A-4C.

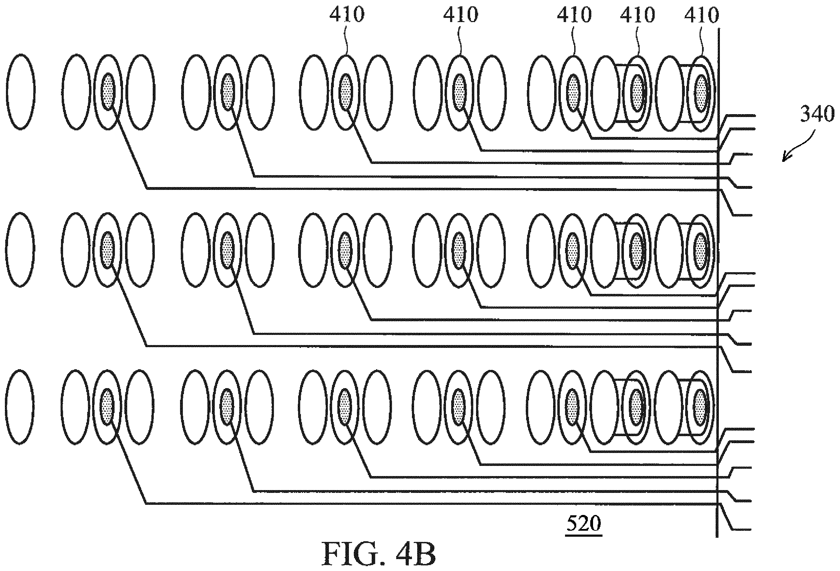

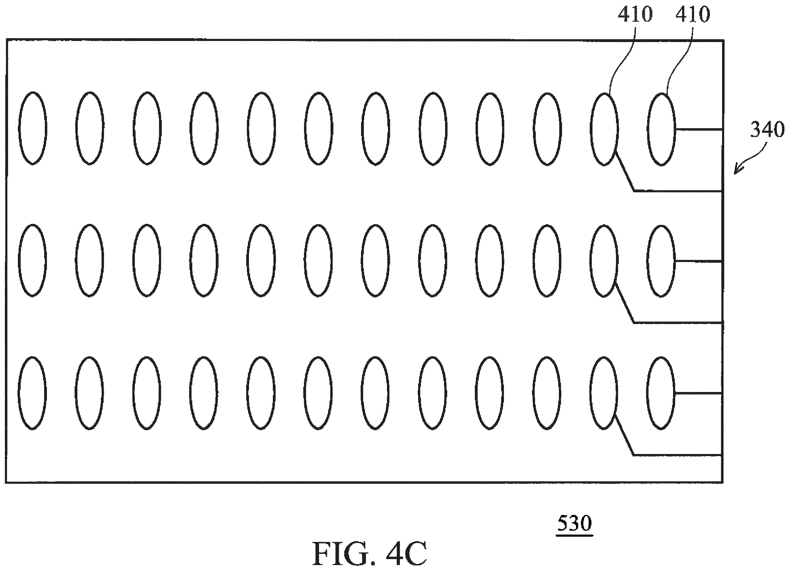

FIG. 4A shows a layout of a first layer 510 (e.g. a top layer) on the PCB 320 of FIG. 3, FIG. 4B shows a layout of a second layer 520 below the first layer 510 on the PCB 320 of FIG. 3, and FIG. 4C shows a layout of a third layer 530 below the second layer 520 on the PCB 320 of FIG. 3. Referring to FIG. 3 and FIGs 4A-4C together, the conductive traces 340 are coupled to the first chip 310 via the bumps 315 of the first chip 310 and a plurality of vias 410 of the PCB 320.

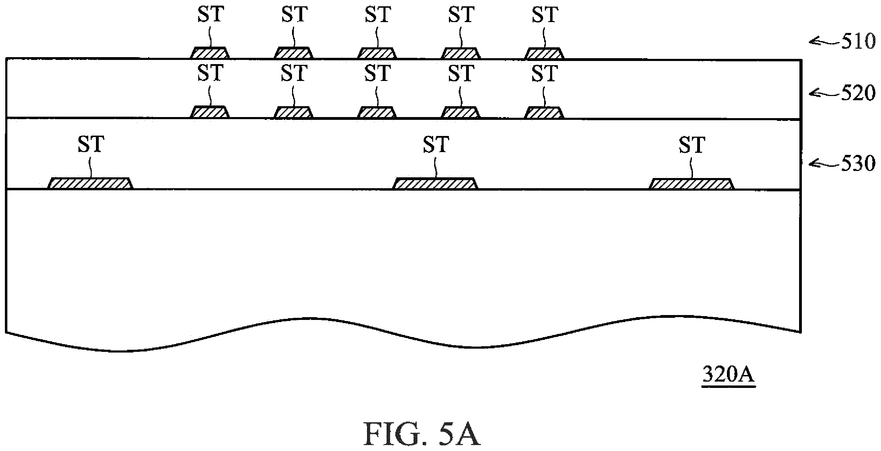

FIG. 5A shows a cross section illustrating the arrangement of the conductive traces 340 of an exemplary PCB 320A along line A-A' of FIG. 3 according to an embodiment of the invention. Referring to FIG. 3 and FIG. 5A together, in the embodiment, the first chip 310 is operating in a normal mode. As described above, all driving units of the first chip 310 are used to provide the data Dₒᵤₜ in the normal mode, thereby all of the conductive traces 340 disposed on the first layer 510, the second layer 520 and the third layer 530 of the PCB 320A function as the signal traces ST for transmitting the data Dₒᵤₜ to the second chip 330.

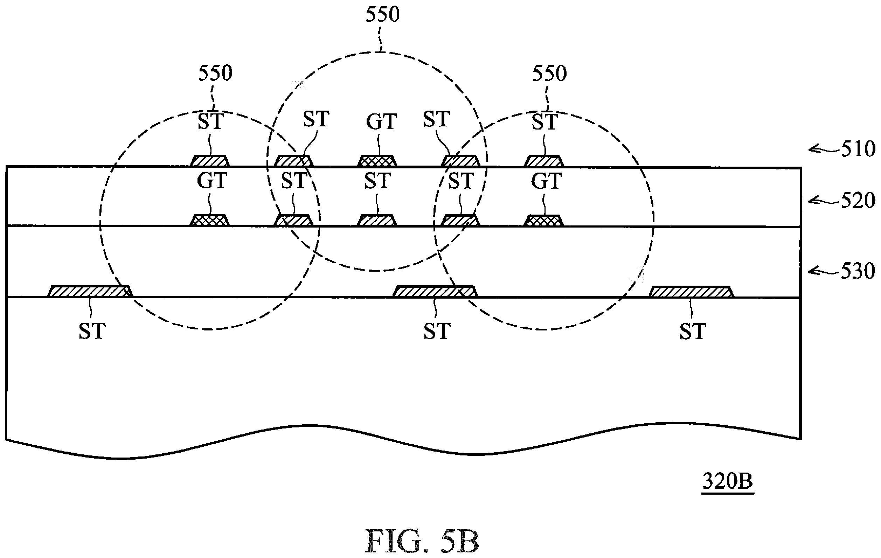

FIG. 5B shows a cross section illustrating the arrangement of the conductive traces 340 of an exemplary PCB 320B along line A-A' of FIG. 3 according to another embodiment of the invention. Referring to FIG. 3 and FIG. 5B together, in the embodiment, the first chip 310 is operating in a high-speed mode. As described above, a portion of driving units of the first chip 310 are selected to provide the data Dₒᵤₜ in the high-speed mode, i.e. not all of the driving units of the first chip 310 are used to provide the data Dₒᵤₜ. Furthermore, the unselected driving units are used to provide at least one shielding pattern. The specific shielding pattern is formed by a ground signal, a power signal or a random signal. In the embodiment, a middle conductive trace 340 in the first layer 510 of the PCB 320B functions as a guard trace GT, and other conductive traces 340 in the first layer 510 of the PCB 320B are the signal traces ST capable of transmitting the corresponding bit signals of the data Dₒᵤₜ to the second chip 330. Furthermore, two outermost conductive trace 340 in the second layer 520 of the PCB 320B functions as the guard traces GT, and other conductive traces 340 in the second layer 520 of the PCB 320B are the signal traces ST capable of transmitting the corresponding bit signals of the data Dₒᵤₜ to the second chip 330. Moreover, the conductive traces 340 in the third layer 530 of the PCB 320B are the signal traces ST capable of transmitting the corresponding bit signals of the data Dₒᵤₜ to the second chip 330. In the embodiment, each guard trace GT can provide a shielding range 550 for reducing interference when the data Dₒᵤₜ is transmitted via the signal traces ST adjacent to the guard trace GT, i.e. the guard trace GT is surrounded by the signal traces ST. Thus, crosstalk is decreased for the signal traces ST. It should be noted that the guard traces GT are separated by the signal traces ST in FIG. 5B. Furthermore, the shielding pattern transmitted by each guard trace GT can be the same or different. Compared with the traditional shielding lines, the guard traces GT of FIG. 5B will not occupy the additional area on the PCB 320B, i.e. the unused conductive traces will be used as the guard traces GT. Specifically, no additional shielding line is fixedly routed and inserted into the conductive traces 340 on the PCB 320B, thus decreasing layout size of the PCB 320B. Furthermore, the arrangement of the conductive traces 340 is determined according to the outputs of the driving units of the first chip 310 via the bumps 315, wherein the outputs of the driving units are controlled by a control circuitry of the first chip 310, e.g. the control circuitry 160 of FIG. 1. The control circuitry of the first chip 310 can modify the arrangement of the conductive traces 340 via the driving units according to actual applications. Furthermore, the guard traces GT can reduce electrical noise from affecting the signals on the PCB 320B. It should be noted that the arrangement of the conductive traces 340 in each layer of the PCB 320B can be swapped. For example, in one embodiment, two outermost conductive trace 340 in the second layer 510 of the PCB 320B could be the guard traces GT, and other conductive traces 340 in the second layer 510 of the PCB 320B could be the signal traces ST. Furthermore, a middle conductive trace 340 in the first layer 520 of the PCB 320B could be a guard trace GT, and other conductive traces 340 in the first layer 520 of the PCB 320B could be the signal traces ST. Furthermore, the number of guard traces GT is less than the number of signal traces ST in FIG. 5B.

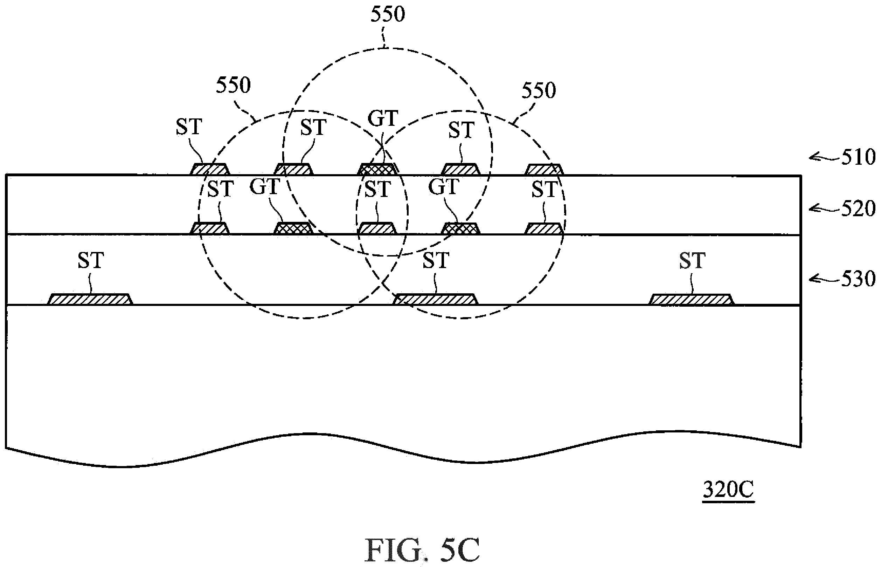

FIG. 5C shows a cross section illustrating the arrangement of the conductive traces 340 of an exemplary PCB 320C along line A-A' of FIG. 3 according to another embodiment of the invention. Referring to FIG. 3 and FIG. 5C together, in the embodiment, the first chip 310 of FIG. 3 is operating in a high-speed mode. Compared with the embodiment of FIG. 5B, the arrangement of the conductive traces 340 in the second layer 520 on the PCB 320B in FIG. 5B is different from the arrangement of the conductive traces 340 in the second layer 520 on the PCB 320C in FIG. 5C. In FIG. 5C, a middle conductive trace 340 and the two outermost conductive trace 340 in the second layer 520 of the PCB 320B are the signal traces ST capable of transmitting the corresponding bit signals of the data Dₒᵤₜ to the second chip 330, and other conductive traces 340 in the second layer 520 of the PCB 320B functions as the guard traces GT. In the embodiment, each guard trace GT can provide a shielding range 550 for reducing interference when the data Dₒᵤₜ is transmitted via the signal traces ST adjacent to the guard trace GT, i.e. the guard trace GT is surrounded by the signal traces ST. As described above, the guard traces GT are separated by the signal traces ST. Furthermore, the shielding pattern transmitted by each guard trace GT can be the same or different. It should be noted that the arrangement of the conductive traces 340 in each layer of the PCB 320C also can be swapped. Furthermore, the number of guard traces GT is less than the number of signal traces ST in FIG. 5C.

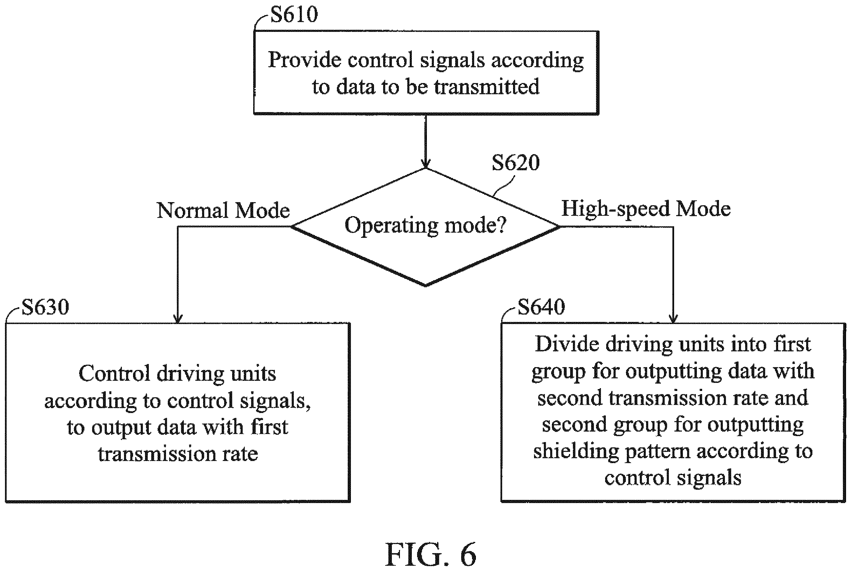

FIG. 6 shows a method for transmitting data from a first chip to a second chip via a plurality of conductive traces of a printed circuit board in an electronic device (e.g. 100 of FIG. 1 or 300 or FIG. 3). In the electronic device, the first chip and the second chip are mounted on the PCB. First, a control circuitry of the first chip provides a plurality of control signals according to the data to be transmitted to the second chip (step S610). Next, it is determined which mode that first chip is operating (step S620). If the first chip is operating in a normal mode, a plurality of driving units of the first chip are controlled according to the control signals, to output the data via the conductive traces of the PCB according to a first transmission rate (step S630). If the first chip is operating in a high-speed mode, the driving units of the first chip are divided into two groups according to the control signals (step S640), wherein a first group of driving units are used to output the data via the signal traces ST of the PCB according to a first transmission rate, and a second group of driving units are used to output at least one specific shielding pattern via the guard traces GT of the PCB according to a second transmission rate. The second transmission rate is higher than the first transmission rate. The specific shielding pattern is formed by a ground signal, a power signal or a random signal. In one embodiment, each guard trace GT is surrounded by the signal traces ST on the PCB. Furthermore, the guard traces GT are separated by the signal traces ST.

According to the embodiments, a control circuitry of a first chip can control the arrangement of the conductive traces between the first chip and a second chip via the driving units of the first chip to transmit the data Dₒᵤₜ to the second chip. In a normal mode, the conductive traces are used to provide the data Dₒᵤₜ to the second chip. In a high-speed mode, a portion of driving units is selected to provide the data Dₒᵤₜ and the remaining driving units are used to provide at least one specific shielding pattern, wherein the specific shielding pattern is formed by a ground signal, a power signal or a random signal. Furthermore, the conductive traces coupled to the selected driving units function as the signal traces ST on the PCB, and the conductive traces coupled to the remainder of the driving units function as the guard traces GT on the PCB. According to the embodiments, no shielding line is fixedly routed and inserted into the conductive traces between the first chip and the second chip on the PCB.

Furthermore, in one embodiment, no matter whether the normal mode or high-speed mode is being used, the unused conductive traces can be used as the guard traces GT so as to provide a shielding range for the adjacent signal traces ST. Therefore, no additional shielding line is fixedly routed and inserted into the signal traces ST on the PCB, thus decreasing layout size of the PCB. Moreover, the arrangement of the conductive traces is determined according to the outputs of the driving units of the first chip via the bumps or pins thereof, wherein the outputs of the driving units are controlled by the control circuitry of the first chip. The control circuitry of the first chip can modify the arrangement of the conductive traces via the driving units according to actual applications, thereby increasing design flexibility.

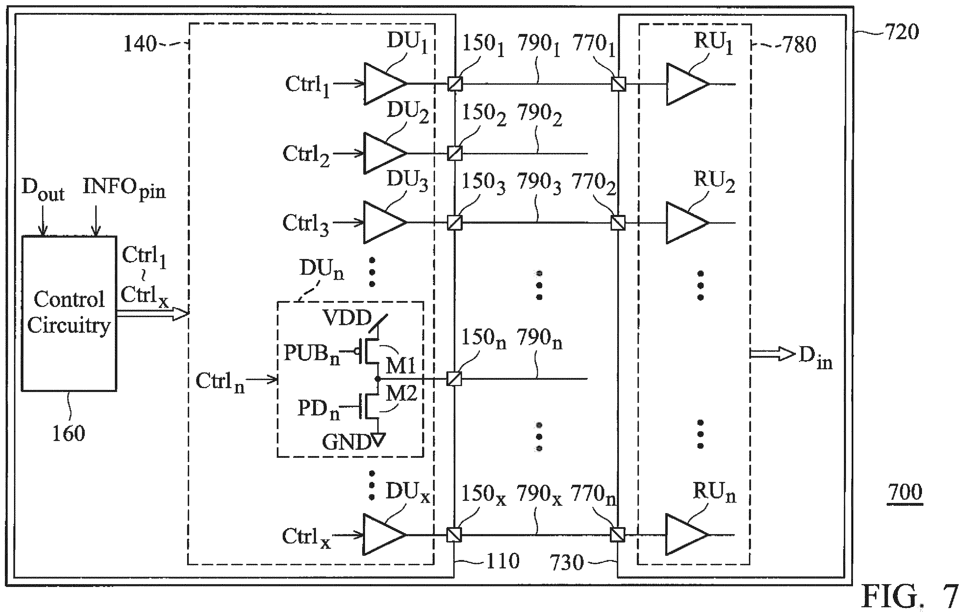

FIG. 7 shows an electronic device 700 according to another embodiment of the invention. The electronic device 700 comprises a first chip 110, a PCB 720, and a second chip 730, wherein the first chip 110 and the second chip 730 are mounted on the PCB 720. In the embodiment, the first chip 110 is operating in a high-speed mode, and the pin information INFOₚᵢₙ indicates that the second chip 730 is a low power double data rate type III (LPDDR3) memory. In the high-speed mode, the first chip 110 can transmit data to the second chip 730 with a double data rate via a plurality of conductive traces 790₁-790ₓ of the PCB 720. In general, the pin number (i.e. the number of pins) of the LPDDR3 memory is less than the pin number of the DDR3. As described above, the first chip 110 comprises an output module 140, a plurality of pins 150₁-150ₓ, and a control circuitry 160. The control circuitry receives data Dₒᵤₜ to be provided to the second chip 730 and pin information INFOₚᵢₙ regarding the pin configuration of the second chip 730, and provides a plurality of control signals Ctrl₁-Ctrlₓ to the second chip 130 according to the data Dₒᵤₜ and the pin information INFOₚᵢₙ. In some embodiments, the data Dₒᵤₜ and the pin information INFOₚᵢₙ are obtained from a circuit (e.g. a memory, a processor or other functional circuitry) of the first chip 110 or a device outside the first chip 110. The output module 140 comprises a plurality of driving units DU₁-Duₓ, wherein an output of each driving unit is coupled to the corresponding pin of the first chip 110. In the embodiment, each of the driving units DU₁-DUₓ has the same circuitry and structure. Furthermore, according to the corresponding control signal, each driving unit can selectively provide 1-bit data of the data Dₒᵤₜ or a constant voltage to the corresponding conductive trace of the PCB 720. For example, according to the control signal Ctrl₁, the driving unit DU₁ can provide 1-bit data of the data Dₒᵤₜ to the conductive trace 790₁ of the PCB 720. Furthermore, according to the control signal Ctrlₙ, the driving unit DUₙ can provide a constant voltage to the conductive trace 790ₙ of the PCB 720.

In FIG. 7, the second chip 730 comprises an input module 780 and a plurality of pins 770₁-770ₙ, wherein the input module 780 comprises a plurality of receiving unit RU₁-RUₙ. Each of the receiving units RU₁-RUₙ is coupled to the corresponding conductive trace of the PCB 720 via the corresponding pin of the second chip 730, and is used to receive a signal transmitted in the corresponding conductive trace. For example, the receiving unit RU₁ is coupled to the conductive trace 790₁ of the PCB 720 via the pin 770₁ of the second chip 730, and the receiving unit RU₂ is coupled to the conductive trace 790₃ of the PCB 720 via the pin 770₂ of the second chip 730. It should be noted that the amount of the pins 770₁-770ₙ of the second chip 730 is less than the amount of the pins 150₁-150ₓ of the first chip 110, i.e. n<x. Thus, the amount of the receiving units RU₁- RUₙ of the second chip 730 is less than the amount of the driving units DU₁- DUₓ of the first chip 110. After receiving the signals, the input module 780 is capable of provide an input data Dᵢₙ according to the received signals for subsequent processing.

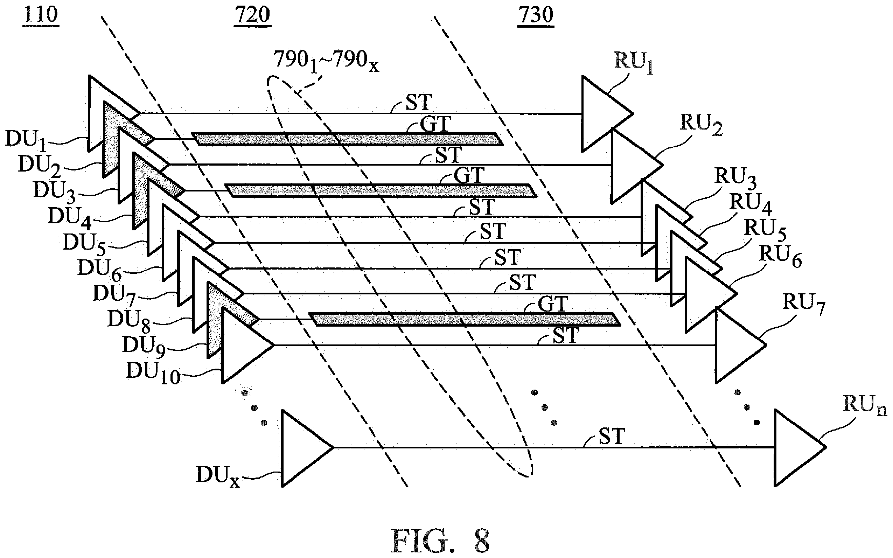

FIG. 8 shows a schematic illustrating the conductive traces 790₁-790ₓ between the first chip 110 and the second chip 730 on the PCB 720 of FIG. 7 according to an embodiment of the invention. In order to simplify the description, the pins of the first chip 110 and the second chip 730 will be omitted in FIG. 8. In the embodiment, the conductive traces 790₁-790ₓ are disposed on the same layer of the PCB 720, e.g. a top layer of the PCB 720. In some embodiments, the conductive traces 790₁-790ₓ may be disposed on different layers of the PCB 120. As described above, according to the control signals Ctrl₁-Ctrlₓ, a portion of driving units are selected from the driving units DU₁-DUₓ to provide the data Dₒᵤₜ, i.e. not all of the driving units DU₁-DUₓ are used to provide the data Dₒᵤₜ. Furthermore, the unselected driving units are used to provide at least one constant voltage, and the constant voltage may be a grounding voltage, a power voltage VDD or an intermediate voltage between the grounding voltage (GND) and the power voltage VDD, such as half of the power voltage VDD (e.g. VDD/2), one-third of the power voltage VDD (e.g. VDD/3), a quarter of the power voltage VDD (e.g. VDD/4), and so on. In some embodiments, the unselected driving units are used to provide various constant voltages. It should be noted that the constant voltages are determined according to actual applications. Furthermore, according to the pin information INFOₚᵢₙ of the second chip 730, the driving units DU₁, DU₃, DU₅₋₈, DU₁₀, ..., DUₓ are selected to provide the data Dₒᵤₜ, thereby the conductive traces of the PCB 720 corresponding to the selected driving units function as the signal traces ST for transmitting the data Dₒᵤₜ to the second chip 730. Moreover, the unselected driving units DU₂, DU₄ and DU₉ are used to provide at least one constant voltage, thereby the conductive traces corresponding to the unselected driving units function as the guard traces GT for reducing crosstalk when the data Dₒᵤₜ is transmitted via the signal traces ST. It should be noted that the conductive traces of the PCB 720 corresponding to the selected driving units DU₁, DU₃, DU₅₋₈, DU₁₀,..., and DUₓ are electrically connected to the second chip 730 on the PCB 720. Moreover, the conductive traces of the PCB 720 corresponding to the unselected driving units DU₂, DU₄ and DU₉ are electrically separated from the second chip 730 on the PCB 720, i.e. the conductive traces of the PCB 720 corresponding to the unselected driving units DU₂, DU₄ and DU₉ are not coupled to the second chip 730. Furthermore, the guard traces GT are separated by the signal traces ST in FIG. 8. Furthermore, the constant voltage transmitted in each guard trace GT can be the same or different. It should be noted that the number of guard traces GT is less than the number of signal traces ST in FIG. 8. In some embodiments, each guard trace GT is surrounded by the signal traces ST on the PCB 720. Furthermore, the guard traces GT are separated by the signal traces ST. In some embodiments, the signal traces ST used to transmit the critical signals, such as a chip select (CS) signal, and a command/address (CA) signal, are separated from each other by the guard traces GT. In some embodiments, the PCB 720 further comprises other devices capable of providing the constant voltages to the corresponding guard traces GT.

Traditionally, after obtaining system specification and requisition, a plurality of shielding lines are implemented on a PCB in order to decrease crosstalk problem, wherein the shielding lines are fixedly routed on the PCB and are also inserted into the conductive traces between the devices on the PCB. In general, the shielding lines are coupled to a ground of the PCB. Compared with the traditional shielding lines, the guard traces GT of FIG. 8 will not occupy the additional area on the PCB, i.e. the guard traces GT are the unused signal traces existing on the PCB 720. Specifically, no additional shielding line is fixedly routed and inserted into the conductive traces on the PCB 720, thus decreasing the layout size of the PCB 720. Furthermore, the arrangement of the conductive traces 790₁-390ₓ is determined according to the pin information INFOₚᵢₙ regarding the second chip 730. The outputs of the driving units DU₁-DUₓ are controlled by the control circuitry 160 of the first chip 110, e.g. the control circuitry 160 of FIG. 1, according to the data Dₒᵤₜ and the pin information INFOₚᵢₙ of the second chip 730. The guard traces GT can reduce electrical noise from affecting the signals between the first chip 110 and the second chip 730 on the PCB 720, e.g. avoiding the signal current loops formed in the conductive traces on the PCB 720. Furthermore, the interconnection between the first chip 110 and the second chip 730 can be planned in advance, and the layout of signals of the interconnection can be minimized due to no additional shielding lines. Furthermore, the development cost of the layout is also decreased.

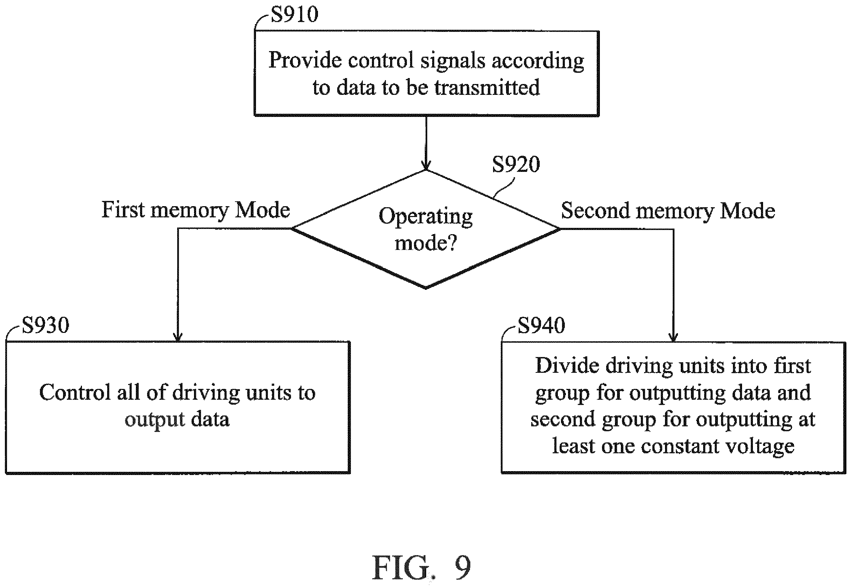

FIG. 9 shows a method for transmitting data from a first chip to a second chip via a plurality of conductive traces of a printed circuit board in an electronic device. In the electronic device, the first chip and the second chip are mounted on the PCB. First, a control circuitry of the first chip provides a plurality of control signals according to the data to be transmitted to the second chip and the pin information INFOₚᵢₙ (step S910). Next, it is determined which mode that first chip is operating according to the pin information INFOₚᵢₙ (step S920). If the first chip is operating in a first memory mode, a plurality of driving units of the first chip are controlled according to the control signals, to output the data via the conductive traces of the PCB (step S930). If the first chip is operating in a second memory mode, the driving units of the first chip are divided into two groups according to the control signals (step S940), wherein a first group of driving units are used to output the data via the signal traces ST of the PCB, and a second group of driving units are used to output at least one constant voltage via the guard traces GT of the PCB. As described above, the guard traces GT and the signal traces ST are coupled to the first chip, wherein the guard traces GT are electrically separated from the second chip, and the signal traces ST are electrically connected to the second chip. Furthermore, the constant voltage transmitted in each guard trace GT can be the same or different. Moreover, the guard traces GT are separated by the signal traces ST. In some embodiments, each signal trace ST used to transmit the critical signal is surrounded by the guard traces GT.

According to the embodiments, a control circuitry of a first chip can control the arrangement of the conductive traces between the first chip and a second chip via the driving units of the first chip to transmit the data Dₒᵤₜ to the second chip. In a first memory mode, the whole driving units are used to provide the data Dₒᵤₜ to the second chip. In a second memory mode, a portion of driving units is selected to provide the data Dₒᵤₜ and the remaining driving units are used to provide at least one constant voltage. Furthermore, the conductive traces coupled to the selected driving units function as the signal traces ST on the PCB, wherein the signal traces ST are electrically connected to the second chip. The conductive traces coupled to the remainder of the driving units function as the guard traces GT on the PCB, wherein the guard traces GT are electrically separated from the second chip. According to the embodiments, no shielding line is fixedly routed and inserted into the conductive traces between the first chip and the second chip on the PCB.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art).

## Claims

1. An electronic device (100) comprising a first chip (110), a second chip (130) and a printed circuit board, PCB, (120),
wherein the PCB (120) comprises a plurality of conductive traces (190; ST, GT) that function as a plurality of signal traces (ST) and a plurality of guard traces (GT); wherein the first chip (110) and the second chip (130) are mounted on the PCB (120)
wherein the first chip comprises an integrated circuit (110), wherein the integrated circuit comprises:
a control circuitry (160), providing a plurality of control signals (Ctrl) according to data (D_out) to be transmitted;
a plurality of pins (150) coupled to the plurality of conductive traces (190; ST, GT) of the printed circuit board, PCB, (120); and
a plurality of driving units (DU) coupled to the conductive traces (190; ST, GT) of the PCB (120) via the pins (150), wherein the driving units (DU) are divided according to the control signals (Ctrl) into a plurality of first driving units and a plurality of second driving units, and according to the control signals (Ctrl), the first driving units provide the data (Dout) to a memory device of the PCB (120) via the corresponding pins (150) and the corresponding conductive traces of the PCB (120) which function as signal traces (ST), and the second driving units provide at least one constant voltage to the corresponding conductive traces of the PCB (120) which function as guard traces (GT) via the corresponding pins (150),
wherein the guard traces (GT) corresponding to the second driving units are separated by the signal traces (ST) corresponding to the first driving units on the PCB (120).

2. The electronic device as claimed in claim 1, wherein the first driving units are electrically connected to the memory device, and the second driving units are electrically separated from the memory device.

3. The electronic device as claimed in one of the preceding claims, wherein each of the conductive traces (190) coupled to the first driving units is a signal trace (ST), and each of the conductive traces (190) coupled to the second driving units is a guard trace (GT).

4. The electronic device as claimed in one of the preceding claims, wherein each of the guard traces (GT) coupled to the second driving units is surrounded by the signal traces (ST) coupled to the first driving units.

5. The electronic device as claimed in one of the preceding claims, further comprising:
a control circuitry (160), providing the plurality of control signals (Ctrl) according to the data (D_out) to be transmitted and pin information (Info_pin) regarding a memory device of the PCB, (120);
wherein when the pin information (Info_pin) indicates that the memory device is a first memory, the control signals (Ctrl) control the driving units (DU) to provide the data (D_out) to the conductive traces (190; ST, GT) of the PCB (120) via the pins (150),
wherein when the pin information (Info_pin) indicates that the memory device is a second memory, the control signals (Ctrl) control a portion of the driving units (DU) to provide the data (D_out) to the corresponding signal traces (ST) of the PCB (120) via the corresponding pins (150), and the control signals (Ctrl) control the other driving units (DU) to provide at least one constant voltage to the corresponding guard traces (GT) of the PCB (120) via the corresponding pins (150),
wherein a pin number of the first memory is greater than a pin number of the second memory.

6. The electronic device as claimed in claim 5, wherein the signal traces (ST) corresponding to the portion of the driving units (DU) are electrically connected to the second memory, and the signal traces (ST) corresponding to the other driving units (DU) are electrically separated from the second memory.

7. The electronic device as claimed in one of claims 5 or 6, wherein each of the guard traces (GT) corresponding to the other driving units (DU) is surrounded by the signal traces (ST) corresponding to the portion of the driving units (DU).

8. The electronic device as claimed in one of claims 5 to 7, wherein the first memory is a double data rate type III, DDR3, memory, and the second memory is a low power double data rate type III, LPDDR3, memory.

9. The electronic device (100) of any of the preceding claims,
wherein the second chip (130) is coupled to the first chip (110) via the signal traces (ST);
wherein the control signals (Ctrl) control the driving units (DU) coupled to the pins (150) corresponding to the signal traces (ST) of the PCB (120) to provide the data (D_out) to the second chip (130), and control the driving units (DU) coupled to the pins (150) corresponding to the guard traces (GT) of the PCB (120) to provide at least one constant voltage to the PCB (120).

10. The electronic device as claimed in claim 9, wherein the signal traces (ST) are electrically connected to the second chip (130) on the PCB (120), and the guard traces (GT) are electrically separated from the second chip (130) on the PCB (120).

11. The electronic device as claimed in claim 9 or 10,
wherein each of the guard traces (GT) is surrounded by the signal traces (ST) on the PCB (120).

12. The electronic device as claimed in one of claims 9 to 11, wherein the guard traces (GT) are separated by the signal traces (ST) on the PCB (120).

13. The electronic device (100) of any of claims 1 to 8,
wherein the second chip (130) is coupled to the first chip (110) via the signal traces (ST);
wherein the control circuitry (160) provides the plurality of control signals (Ctrl) to the second chip (130), wherein the second chip (130) is the memory device.

14. The electronic device as claimed in one of the preceding claims, wherein the constant voltage is a grounding voltage, a power voltage or an intermediate voltage between the grounding voltage and the power voltage.

15. A method for transmitting data (D_out) from a first chip (110) to a second chip (130) via a plurality of signal traces (ST) of a printed circuit board, PCB, (120) in an electronic device (100) according to claim 1, comprising:
providing (S610) a plurality of control signals (Ctrl) according to the data (D_out) to be transmitted to the second chip (130) and pin information (Info_pin) regarding the second chip (130), by the control circuitry (160) of the first chip (110);
controlling (S630) a plurality of first driving units (DU) to provide the data (D_out) to the second chip (130) via signal traces (ST) of the PCB (120), by the control circuitry (160) of the first chip (110); and
controlling a plurality of second driving units (DU) to provide at least one constant voltage to the PCB (120) via guard traces (GT) of the PCB (120), by the control circuitry (160) of the first chip (110),
wherein the signal traces (ST) are electrically connected to the second chip (130) on the PCB (120), and the guard traces (GT) are electrically separated from the second chip (130) on the PCB (120),
wherein each of the guard traces (GT) is surrounded by the signal traces (ST) on the PCB (120).

## Patentansprüche

1. Elektronische Vorrichtung (100), aufweisend einen ersten Chip (110), einen zweiten Chip (130) und eine Leiterplatte (120),
wobei die Leiterplatte (120) mehrere Leiterbahnen (190; ST, GT) aufweist, die als mehrere Signalbahnen (ST) und mehrere Schutzbahnen (GT) dienen;
wobei der erste Chip (110) und der zweite Chip (130) auf der Leiterplatte (120) angebracht sind,
wobei der erste Chip eine integrierte Schaltung (110) aufweist, wobei die integrierte Schaltung aufweist:
eine Steuerschaltung (160), die mehrere Steuersignale (Ctrl) gemäß zu übertragenden Daten (D_out) bereitstellt;
mehrere Pins (150), die mit den mehreren Leiterbahnen (190; ST, GT) der Leiterplatte (120) gekoppelt sind; und
mehrere Treibereinheiten (DU), die über die Pins (150) mit den Leiterbahnen (190; ST, GT) der Leiterplatte (120) gekoppelt sind, wobei die Treibereinheiten (DU) gemäß den Steuersignalen (Ctrl) in mehrere erste Treibereinheiten und mehrere zweite Treibereinheiten geteilt sind und wobei, gemäß den Steuersignalen (Ctrl), die ersten Treibereinheiten die Daten (Dout) über die jeweiligen Pins (150) und die jeweiligen Leiterbahnen der Leiterplatte (120), die als Signalbahnen (ST) dienen, an einer Speichervorrichtung der Leiterplatte (120) bereitstellen und wobei die zweiten Treibereinheiten mindestens eine konstante Spannung über die jeweiligen Pins (150) an den jeweiligen Leiterbahnen der Leiterplatte (120) bereitstellen, die als Schutzbahnen (GT) dienen,
wobei die Schutzbahnen (GT), die den zweiten Treibereinheiten entsprechen, auf der Leiterplatte (120) durch die Signalbahnen (ST), die den ersten Treibereinheiten entsprechen, getrennt sind.

2. Elektronische Vorrichtung nach Anspruch 1, wobei die ersten Treibereinheiten mit der Speichervorrichtung elektrisch verbunden sind und die zweiten Treibereinheiten von der Speichervorrichtung elektrisch getrennt sind.

3. Elektronische Vorrichtung nach einem der vorhergehenden Ansprüche, wobei jede der Leiterbahnen (190), die mit den ersten Treibereinheiten gekoppelt ist, eine Signalbahn (ST) ist und jede der Leiterbahnen (190), die mit den zweiten Treibereinheiten gekoppelt ist, eine Schutzbahn (GT) ist.

4. Elektronische Vorrichtung nach einem der vorhergehenden Ansprüche, wobei jede der Schutzbahnen (GT), die mit den zweiten Treibereinheiten gekoppelt ist, von den Signalbahnen (ST) umgeben ist, die mit den ersten Treibereinheiten gekoppelt sind.

5. Elektronische Vorrichtung nach einem der vorhergehenden Ansprüche, ferner aufweisend:
eine Steuerschaltung (160), die die mehreren Steuersignale (Ctrl) gemäß den zu übertragenden Daten (D_out) und einer Pin-Information (Info_pin) betreffend eine Speichervorrichtung der Leiterplatte (120) bereitstellt;
wobei, wenn die Pin-Information (Info_pin) angibt, dass die Speichervorrichtung ein erster Speicher ist, die Steuersignale (Ctrl) die Treibereinheiten (DU) so steuern, dass die Daten (D_out) über die Pins (150) an den Leiterbahnen (190; ST, GT) der Leiterplatte (120) bereitgestellt werden,
wobei, wenn die Pin-Information (Info_pin) angibt, dass die Speichervorrichtung ein zweiter Speicher ist, die Steuersignale (Ctrl) einen Teil der Treibereinheiten (DU) so steuern, dass die Daten (D_out) über die entsprechenden Pins (150) an den entsprechenden Signalbahnen (ST) der Leiterplatte (120) bereitgestellt werden, und die Steuersignale (Ctrl) die anderen Treibereinheiten (DU) so steuern, dass mindestens eine konstante Spannung über die entsprechenden Pins (150) an den jeweiligen Schutzbahnen (GT) der Leiterplatte (120) bereitgestellt wird,
wobei eine Pin-Anzahl des ersten Speichers größer als eine Pin-Anzahl des zweiten Speichers ist.

6. Elektronische Vorrichtung nach Anspruch 5, wobei die Signalbahnen (ST), die dem Teil der Treibereinheiten (DU) entsprechen, mit dem zweiten Speicher elektrisch verbunden sind und die Signalbahnen (ST), die den anderen Treibereinheiten (DU) entsprechen, elektrisch von dem zweiten Speicher getrennt sind.

7. Elektronische Vorrichtung nach einem der Ansprüche 5 oder 6, wobei jede der Schutzbahnen (GT), die den anderen Treibereinheiten (DU) entsprechen, von den Signalbahnen (ST) umgeben ist, die dem Teil der Treibereinheiten (DU) entsprechen.

8. Elektronische Vorrichtung nach einem der Ansprüche 5 bis 7, wobei der erste Speicher ein Doppeldatenratenspeicher vom Typ III, DDR3-Speicher, ist und der zweite Speicher ein Niedrigenergie-Doppeldatenratenspeicher vom Typ III, LPDDR3-Speicher, ist.

9. Elektronische Vorrichtung (100) nach einem der vorhergehenden Ansprüche,
wobei der zweite Chip (130) über die Signalbahnen (ST) mit dem ersten Chip (110) gekoppelt ist;
wobei die Steuersignale (Ctrl) die Treibereinheiten (DU), die mit den Pins (150) gekoppelt sind, welche den Signalbahnen (ST) der Leiterplatte (120) entsprechen, so steuern, dass die Daten (D_out) an dem zweiten Chip (130) bereitgestellt werden, und die Treibereinheiten (DU), die mit den Pins (150) gekoppelt sind, welche den Schutzbahnen (GT) der Leiterplatte (120) entsprechen, so steuern, dass mindestens eine konstante Spannung an der Leiterplatte (120) bereitgestellt wird.

10. Elektronische Vorrichtung nach Anspruch 9, wobei die Signalbahnen (ST) auf der Leiterplatte (120) elektrisch mit dem zweiten Chip (130) verbunden sind und die Schutzbahnen (GT) auf der Leiterplatte (120) elektrisch von dem zweiten Chip (130) getrennt sind.

11. Elektronische Vorrichtung nach Anspruch 9 oder 10,
wobei jede der Schutzbahnen (GT) auf der Leiterplatte (120) von den Signalbahnen (ST) umgeben ist.

12. Elektronische Vorrichtung nach einem der Ansprüche 9 bis 11, wobei die Schutzbahnen (GT) auf der Leiterplatte (120) durch die Signalbahnen (ST) voneinander getrennt sind.

13. Elektronische Vorrichtung (100) nach einem beliebigen der Ansprüche 1 bis 8,
wobei der zweite Chip (130) über die Signalbahnen (ST) mit dem ersten Chip (110) gekoppelt ist;
wobei die Steuerschaltung (160) die mehreren Steuersignale (Ctrl) an dem zweiten Chip (130) bereitstellt, wobei der zweite Chip (130) die Speichervorrichtung ist.

14. Elektronische Vorrichtung nach einem der vorhergehenden Ansprüche, wobei die konstante Spannung eine Massespannung, eine Versorgungsspannung oder eine Zwischenspannung zwischen der Massespannung und der Versorgungsspannung ist.

15. Verfahren zum Übertragen von Daten (D_out) von einem ersten Chip (110) an einen zweiten Chip (130) über mehrere Signalbahnen (ST) einer Leiterplatte (120) in einer elektronischen Vorrichtung (100) nach Anspruch 1, umfassend:
Bereitstellen (S610) von mehreren Steuersignalen (Ctrl) gemäß den Daten (D_out), die an den zweiten Chip (130) zu übertragen sind, und einer Pin-Information (Info_pin), die den zweiten Chip (130) betreffen, durch die Steuerschaltung (160) des ersten Chips (110);
Steuern (S630) von mehreren ersten Treibereinheiten (DU), um die Daten (D_out) über Signalbahnen (ST) der Leiterplatte (120) an dem zweiten Chip (130) bereitzustellen, durch die Steuerschaltung (160) des ersten Chips (110); und
Steuern von mehreren zweiten Treibereinheiten (DU), um über Schutzbahnen (GT) der Leiterplatte (120) mindestens eine konstante Spannung an der Leiterplatte (120) bereitzustellen, durch die Steuerschaltung (160) des ersten Chips (110),
wobei die Signalbahnen (ST) auf der Leiterplatte (120) elektrisch mit dem zweiten Chip (130) verbunden sind und die Schutzbahnen (GT) auf der Leiterplatte (120) elektrisch von dem zweiten Chip (130) getrennt sind,
wobei jede der Schutzbahnen (GT) auf der Leiterplatte (120) von den Signalbahnen (ST) umgeben ist.

## Revendications

1. Dispositif électronique (100) comprenant une première puce (110), une seconde puce (130), et une carte de circuit imprimé, PCB, (120) ;
dans lequel la carte PCB (120) comprend une pluralité de pistes conductrices (190 ; ST, GT) qui fonctionnent en tant qu'une pluralité de pistes de signal (ST) et qu'une pluralité de pistes de garde (GT) ;
dans lequel la première puce (110) et la seconde puce (130) sont montées sur la carte PCB (120) ;
dans lequel la première puce comprend un circuit intégré (110), dans lequel le circuit intégré comprend :
un montage de circuits de commande (160), fournissant une pluralité de signaux de commande (Ctrl) selon des données (D_out) à transmettre ;
une pluralité de broches (150) couplées à la pluralité de pistes conductrices (190 ; ST, GT) de la carte de circuit imprimé, PCB, (120) ; et
une pluralité d'unités d'attaque (DU) couplées aux pistes conductrices (190 ; ST, GT) de la carte PCB (120) par l'intermédiaire des broches (150), dans lequel les unités d'attaque (DU) sont divisées, selon les signaux de commande (Ctrl), en une pluralité de premières unités d'attaque et une pluralité de secondes unités d'attaque, et selon les signaux de commande (Ctrl), les premières unités d'attaque fournissent les données (D_out) à un dispositif de mémoire de la carte PCB (120) par l'intermédiaire des broches correspondantes (150), et des pistes conductrices correspondantes de la carte PCB (120) qui fonctionnent en tant que des pistes de signal (ST), et les secondes unités d'attaque fournissent au moins une tension constante aux pistes conductrices correspondantes de la carte PCB (120) qui fonctionnent en tant que des pistes de garde (GT) par l'intermédiaire des broches correspondantes (150) ;
dans lequel les pistes de garde (GT) correspondant aux secondes unités d'attaque sont séparées par les pistes de signal (ST) correspondant aux premières unités d'attaque sur la carte PCB (120).

2. Dispositif électronique selon la revendication 1, dans lequel les premières unités d'attaque sont électriquement connectées au dispositif de mémoire, et les secondes unités d'attaque sont électriquement séparées du dispositif de mémoire.

3. Dispositif électronique selon l'une quelconque des revendications précédentes, dans lequel chacune des pistes conductrices (190) couplées aux premières unités d'attaque correspond à une piste de signal (ST), et chacune des pistes conductrices (190) couplées aux secondes unités d'attaque correspond à une piste de garde (GT).

4. Dispositif électronique selon l'une quelconque des revendications précédentes, dans lequel chacune des pistes de garde (GT) couplées aux secondes unités d'attaque est entourée par les pistes de signal (ST) couplées aux premières unités d'attaque.

5. Dispositif électronique selon l'une quelconque des revendications précédentes, comprenant en outre :
un montage de circuits de commande (160), fournissant la pluralité de signaux de commande (Ctrl) selon les données (D_out) à transmettre et des informations de broche (Info_pin) concernant un dispositif de mémoire de la carte PCB (120) ;
dans lequel, lorsque les informations de broches (Info_pin) indiquent que le dispositif de mémoire est une première mémoire, les signaux de commande (Ctrl) commandent aux unités d'attaque (DU) de fournir les données (D_out) aux pistes conductrices (190 ; ST, GT) de la carte PCB (120), par l'intermédiaire des broches (150) ;
dans lequel, lorsque les informations de broche (Info_pin) indiquent que le dispositif de mémoire est une seconde mémoire, les signaux de commande (Ctrl) commandent, à une partie des unités d'attaque (DU), de fournir les données (D_out) aux pistes de signal correspondantes (ST) de la carte PCB (120), par l'intermédiaire des broches correspondantes (150), et les signaux de commande (Ctrl) commandent, aux autres unités d'attaque (DU), de fournir au moins une tension constante aux pistes de garde correspondantes (GT) de la carte PCB (120), par l'intermédiaire des broches correspondantes (150) ;
dans lequel un nombre de broches de la première mémoire est supérieur à un nombre de broches de la seconde mémoire.

6. Dispositif électronique selon la revendication 5, dans lequel les pistes de signal (ST) correspondant à la partie des unités d'attaque (DU) sont électriquement connectées à la seconde mémoire, et les pistes de signal (ST) correspondant aux autres unités d'attaque (DU) sont électriquement séparées de la seconde mémoire.

7. Dispositif électronique selon l'une quelconque des revendications 5 et 6, dans lequel chacune des pistes de garde (GT) correspondant aux autres unités d'attaque (DU) est entourée par les pistes de signal (ST) correspondant à la partie des unités d'attaque (DU).

8. Dispositif électronique selon l'une quelconque des revendications 5 à 7, dans lequel la première mémoire est une mémoire de type III à double débit de données, DDR3, et la seconde mémoire est une mémoire de type III à double débit de données et faible consommation d'énergie, LPDDR3.

9. Dispositif électronique (100) selon l'une quelconque des revendications précédentes,
dans lequel la seconde puce (130) est couplée à la première puce (110) par l'intermédiaire des pistes de signal (ST) ;
dans lequel les signaux de commande (Ctrl) commandent, aux unités d'attaque (DU) couplées aux broches (150) correspondant aux pistes de signal (ST) de la carte PCB (120), de fournir les données (D_out) à la seconde puce (130), et commandent, aux unités d'attaque (DU) couplées aux broches (150) correspondant aux pistes de garde (GT) de la carte PCB (120), de fournir au moins une tension constante à la carte PCB (120).

10. Dispositif électronique selon la revendication 9, dans lequel les pistes de signal (ST) sont électriquement connectées à la seconde puce (130) sur la carte PCB (120), et les pistes de garde (GT) sont électriquement séparées de la seconde puce (130) sur la carte PCB (120).

11. Dispositif électronique selon la revendication 9 ou 10,
dans lequel chacune des pistes de garde (GT) est entourée par les pistes de signal (ST) sur la carte PCB (120).

12. Dispositif électronique selon l'une quelconque des revendications 9 à 11, dans lequel les pistes de garde (GT) sont séparées par les pistes de signal (ST) sur la carte PCB (120).

13. Dispositif électronique (100) selon l'une quelconque des revendications 1 à 8,
dans lequel la seconde puce (130) est couplée à la première puce (110) par l'intermédiaire des pistes de signal (ST) ;
dans lequel le montage de circuits de commande (160) fournit la pluralité de signaux de commande (Ctrl) à la seconde puce (130), dans lequel la seconde puce (130) est le dispositif de mémoire.

14. Dispositif électronique selon l'une quelconque des revendications précédentes, dans lequel la tension constante est une tension de mise à la terre, une tension d'alimentation ou une tension intermédiaire entre la tension de mise à la terre et la tension d'alimentation.

15. Procédé de transmission de données (D_out), d'une première puce (110) à une seconde puce (130), par l'intermédiaire d'une pluralité de pistes de signal (ST) d'une carte de circuit imprimé, PCB, (120) dans un dispositif électronique (100) selon la revendication 1, le procédé comprenant les étapes ci-dessous consistant à :
fournir (S610) une pluralité de signaux de commande (Ctrl) selon les données (D_out) à transmettre à la seconde puce (130) et des informations de broche (Info_pin) concernant la seconde puce (130), par le biais du montage de circuits de commande (160) de la première puce (110) ;
commander (S630), à une pluralité de premières unités d'attaque (DU), de fournir les données (D_out) à la seconde puce (130), par l'intermédiaire de pistes de signal (ST) de la carte PCB (120), par le biais du montage de circuits de commande (160) de la première puce (110) ; et
commander, à une pluralité de secondes unités d'attaque (DU), de fournir au moins une tension constante à la carte PCB (120) par l'intermédiaire de pistes de garde (GT) de la carte PCB (120), par le biais du montage de circuits de commande (160) de la première puce (110) ;
dans lequel les pistes de signal (ST) sont électriquement connectées à la seconde puce (130) sur la carte PCB (120), et les pistes de garde (GT) sont électriquement séparées de la seconde puce (130) sur la carte PCB (120) ;
dans lequel chacune des pistes de garde (GT) est entourée par les pistes de signal (ST) sur la carte PCB (120).
